# EUROPÄISCHE PATENTSCHRIFT

(11) **EP 1 659 412 B1**
(45) Veröffentlichungstag und Bekanntmachung des Hinweises auf die Patenterteilung: **20.01.2016**
(21) Anmeldenummer: 05024614.9
(22) Anmeldetag: 11.11.2005
(51) Int. Cl.: G01R 22/06, H02B 1/052, H02B 1/03

(54) **Vorrichtung zur Fixierung einer Plattform zum Halten und Führen eines Stromzählers in einem Zählerschrank**
Device for fixing a platform for supporting and connecting an electric meter within an electric meter cabinet
Dispositif de fixation d'une plateforme destinée à la fixation et au guidage d'un compteur de courant dans une armoire de compteurs

(30) Priorität: 23.11.2004 DE 202004018131 U
(43) Veröffentlichungstag der Anmeldung: 24.05.2006
(73) Patentinhaber: ABB AG, 68309 Mannheim (DE)
(72) Erfinder: Eppe, Klaus-Peter, 69429 Waldbrunn (DE); Wieland, Ralf, 69429 Waldbrunn (DE)

(56) Entgegenhaltungen:
- DE-A1- 2 618 287
- DE-A1- 3 136 545
- DE-A1- 10 261 206
- GB-A- 350 990
- US-B1- 6 278 605
- US-B1- 6 563 697

## Beschreibung

Die Erfindung betrifft eine Plattform zum Aufstecken eines Stromzählers.

Im Verteilerbau, insbesondere in der Hausinstallation, geht die Tendenz dazu, den mechanischen Stromzähler durch einen elektronischen Stromzähler zu ersetzen. Dieser Stromzähler besitzt auf seiner Unterseite Kontaktfahnen und Haltekrallen.

Bei den alten Zählerplätzen mit einem Zählerkreuz wird auf das Zählerkreuz ein Adapter aufgesetzt, auf den der elektronische Zähler befestigt wird, was auf einfache Weise dadurch erfolgen kann, dass die Kontaktfahnen und die Haltekrallen in geeignete Öffnungen auf der Aufsetzplatte des Adapters eingeführt werden. Beim Einführen werden im Inneren des Adapters befindliche Kontaktstellen kontaktiert, dergestalt, dass bei montiertem Zähler der Strom über den Zähler und bei demontiertem Zähler der Strom über den Adapter fließt, wobei aufgrund der konstruktiven Ausgestaltung eine Stromunterbrechung bei der Montage und Demontage vermieden wird.

Die GB 350 990 A zeigt eine Anordnung von Anschlussklemmen (Terminal Blocks) auf einer Profiltragschiene.

Die DE 102 61 206 A1 zeigt eine Vorrichtung zur Ankopplung eines Stromzählers an eine Trägerplattform, umfassend einen Adapter, der auf dem Zählerkreuz eines Zählerplatzes montiert werden kann.

Wenn die Einheit, auf die der Zähler aufgesetzt werden soll, im Zählerschrank integriert ist, besteht das Problem, wie die Plattform zur Aufnahme des Stromzählers auf einfache

Die DE 2618287 zeigt eine Vorrichtung zur Fixierung einer massiven Platte, auf der ein elektrisches Installationsschaltgerät gehalten ist, auf einer Halteschiene, beispielsweise innerhalb einer Installationsverteilung. Die Platte weist auf ihrer Unterseite eine U-förmige Ausnehmung auf, deren eine Seitenwand eine Nase und deren andere Seitenwand einen in die Ausnehmung hineinragenden Schieber aufweist, in der Art, dass Nase und Schieber im aufgeschnappten Zustand die abgebogenen Schenkelenden der Halteschiene hintergreifen.

Die US 6563697 offenbart einen Stromzähler, der auf einer Halteschiene befestigt ist. Dabei umfasst der Zähler eine Zählerbasis und eine mit der Zählerbasis fest verbundene Abdeckung. Der Zähler ist mit seiner Zählerbasis direkt und ohne Zwischenschaltung eines Adapters auf einer Halteschiene befestigt.

Aufgabe der Erfindung ist es, eine Vorrichtung der eingangs genannten Art so auszubilden, dass die Plattform einfach und schnell montiert werden kann.

Diese Aufgabe wird erfindungsgemäß gelöst durch die Merkmale des Anspruches 1.

Danach ist die Plattform mit einem Gehäuse gebildet, auf dessen Unterseite eine Aussparung vorgesehen ist, an deren einer Endwand eine zur anderen Endwand hinweisende feststehende und an deren anderen Endwand eine federnd in Richtung zur feststehenden Nase gedrückte bewegliche Nase vorgesehen ist, mit denen die Plattform hinter entgegengesetzt liegenden Kanten wenigstens einer Halteschienen schnappbar ist.

Solche Schnellbefestigungsanordnungen sind insbesondere bei Leitungsschutzschaltern oder Fehlerstromschutzschaltern bekannt geworden. Für eine Plattform zur Aufnahme eines Stromzählers jedoch hat eine solche Schnellbefestigung bisher keine Verwendung gefunden.

Gemäß einer vorteilhaften Ausgestaltung der Erfindung sind im Zählerplatz parallel verlaufende, nebeneinander und im montierten Zustand übereinander verlaufende Schienen vorgesehen, die entweder aus Flachbandmaterial oder aus einer Hutprofilschiene gebildet sind.

Bei einer besonders vorteilhaften Ausgestaltung sind zwei Hutprofilschienen nebeneinander angeordnet, auf die die Plattform aufgerastet wird.

Weitere vorteilhafte Ausgestaltungen und Verbesserungen der Erfindung sind den weiteren Unteransprüchen zu entnehmen.

Anhand der Zeichnung, in der zwei Ausführungsbeispiele der Erfindung näher dargestellt sind, sollen die Erfindung sowie weitere vorteilhafte Ausgestaltungen und Verbesserungen der Erfindung näher erläutert und beschrieben werden.

Es zeigen:
- Fig. 1: eine Schnittansicht in einem Zählerplatz einer ersten Ausführungsform,
- Fig. 2: eine Anordnung ähnlich Fig. 1 in einer zweiten Ausführungsform und
- Fig. 3: eine perspektivische Ansicht auf die Anordnung gemäß Fig. 2, von unten.

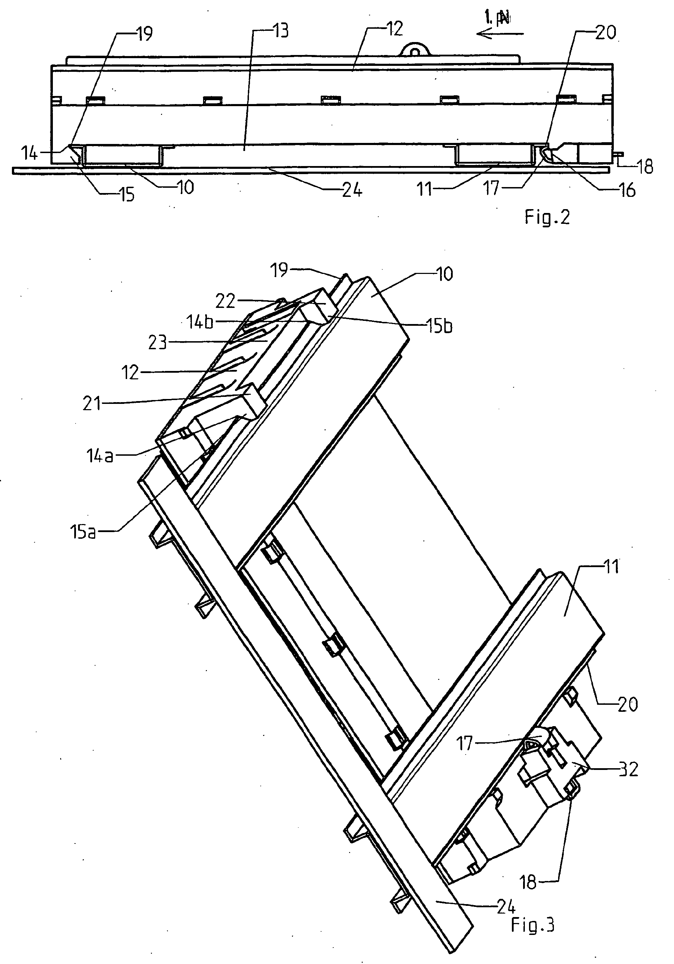

Es sei nun Bezug genommen auf die Fig. 3.

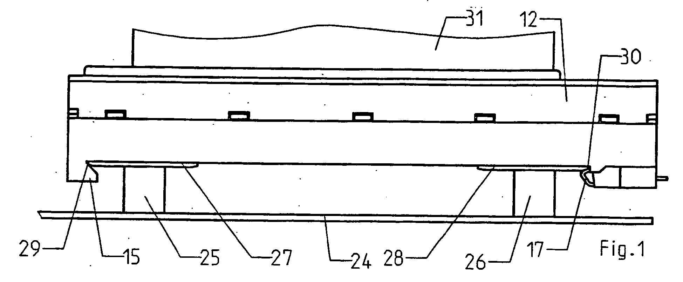

Innerhalb eines nicht näher dargestellten Zählerplatzes sind zwei horizontal verlaufende Hutprofilschienen 10 und 11 angebracht, auf denen eine Plattform 12 zur Aufnahme eines elektronischen Stromzählers 31 (siehe Fig. 1) aufgerastet ist.

Die Plattform 12 ist durch ein quaderförmiges Gehäuse gebildet, in dessen Innerem hier nicht weiter interessierende Kontaktelemente vorgesehen sind. Auf der Bodenunterseite des Gehäuses ist eine Art Aussparung 13 vorgesehen, die eine erste Endwand 14 aufweist, an der eine feststehende Nase 15 angeformt ist. Wie dies im einzelnen ausgestaltet ist, wird weiter unten näher erläutert. An der entgegen gesetzt liegenden Endwand 16 ist eine bewegliche Nase 17 angeformt, die innerhalb des Gehäuses 12 unter dem Druck einer nicht näher dargestellten Feder dauernd in Richtung P beaufschlagt ist. Die bewegbare Nase 17 ragt mit einer Art Fahne 18 aus dem Gehäuse 12 heraus, so dass sie entgegen der Pfeilrichtung P nach außen aus der Ausnehmung 13 herausgezogen werden kann.

Im montierten Zustand greift die Nase 15 hinter eine Kante 19 der Hutprofilschiene 10, wobei die bewegbare Nase 17 hinter eine Kante 20 der Hutprofiltragschiene 11 geschnappt ist. Die Kanten 19 und 20 sind entgegengesetzt liegende Kanten der beiden parallel verlaufenden Hutprofiltragschienen 10, 11.

Die Ausnehmung 13 wird, wie in der Fig. 3 dargestellt, dadurch gebildet, dass am Boden des Gehäuses 12 an der Kante, die der Hutprofiltragschiene benachbart ist, zwei Vorsprünge 21 und 22 vorgesehen sind, an deren der freien Seitenkante 23 des Gehäuses 12 entgegengesetzt liegenden Fläche je eine feststehende Nase 15a und 15b angeformt sind. Die erste Endwand 14 ist damit durch zwei Teilendwände 14a, 14b gebildet. Von den Nasen 15a, 15b ist in Fig. 1 nur die eine Nase zu sehen, die die Bezugsziffer 15 erhalten hat. Natürlich kann auch nur eine Nase vorgesehen sein, die die gesamte Breite des Gehäuses 12 überdeckt, oder die etwa mittig angeordnet ist, der beweglichen Nase gegenüber liegend. Zwei Nasen 15am 15b sind z. B. aus Gründen der Verdrehsicherheit günstiger.

An der entgegengesetzt liegenden Kante, die der Hutprofiltragschiene 11 benachbart ist und die Bezugsziffer 24 trägt, ist ein in der Ausführung gemäß Fig. 3 etwa T-förmig ausgebildeter Gehäusevorsprung 25 vorgesehen, in dem die bewegliche Nase 17 geführt ist und aus dem die Fahne 18 herausragt. Dieser Gehäusevorsprung 25 ist mittig zwischen den beiden Vorsprüngen 21 und 22 gelegen.

Die Fig. 3 zeigt die Anordnung in montierter Form; hieraus ist ersichtlich, dass die beiden Nasen 15a, 15b; 15 sich in montierten Zustand oben befinden, wogegen die bewegliche Nase 17 unten gelegen ist. Zur Montage werden die beiden Nasen 15a, 15b hinter die Kante 19 gehängt, so dass sich das Gehäuse 12 um einen Drehpunkt verschwenken lässt, der durch die Kante 19 und die Teilendwände 14a, 14b mit den Nasen 15a, 15b gebildet ist. Wenn der Gehäuseboden gegen die untere Tragschiene 11 zum Anliegen gekommen ist, hat die bewegliche Nase 17 die untere Kante 20 hintergriffen.

Bei der Ausführung gemäß Fig. 2 liegen die beiden Hutprofiltragschienen horizontal auf einer Innenfläche 24 eines Zählerschrankes, wobei die Innenfläche 24, wie aus Fig. 3 ersichtlich ist, vertikal verläuft.

Anstatt der beiden Hutprofiltragschienen könnten, wie aus Fig. 1 ersichtlich ist, auf der Innenfläche des Zählerschrankes Fixierungspfosten 25 und 26 aufgesetzt werden, auf denen Flachbandschienen 27 und 28 befestigt sind; die Fixierung des Gehäuses 12 erfolgt in gleicher Weise wie bei den Hutprofiltragschienen 10, 11, in dem die feststehenden Nasen 15, 15a, 15b hinter die eine Kante 29 der Schiene 27 gesetzt, d. h. eingehängt, und die bewegliche Nase 17 hinter die entgegengesetzt liegenden Kante 30 der Schiene 28 gerastet werden.

Auf das Gehäuse 12 wird, wie in Fig. 1 strichliert dargestellt, ein Stromzähler 31 aufgesetzt.

Es besteht auch die Möglichkeit, die Nasen, die in der Zeichnung als beweglich dargestellt sind, feststehend auszugestalten und die Verrastungsmöglichkeit an der unteren Hutprofilschiene 11 oder Flachbandschiene 28 vorzusehen.

## Patentansprüche

1. Plattform (12) zum Aufstecken eines Stromzählers, wobei die Plattform (12) durch ein Gehäuse gebildet ist, in dessen Innerem Kontaktelemente vorgesehen sind, auf dessen Unterseite eine Aussparung vorgesehen ist, an deren eine Endwand (14) wenigstens eine zur anderen Endwand (16) hinweisende feststehende Nase (15) und an deren anderen Endwand wenigstens eine federnd in Richtung zur feststehenden Nase (15) gedrückte bewegliche Nase (17) vorgesehen sind, so dass das Gehäuse der Plattform (12) hinter entgegengesetzt liegende Kanten (19, 20; 29, 30) wenigstens einer Halteschiene (10, 11; 27, 28) schnappbar ist.

2. Plattform (12) nach Anspruch 1, wobei je eine feststehende Nase (15) an zwei entgegengesetzt liegenden Vorsprüngen (21, 22) angeformt sind, die senkrecht von der Bodenfläche des Gehäuses (12) vorspringen.

3. Plattform (12) nach Anspruch 2, wobei an der entgegengesetzten Schmalseitenkante des Gehäuses (12) wenigstens ein Gehäusevorsprung (25) vorgesehen ist, der zwischen den beiden Vorsprüngen (21, 22) angeordnet und von je einer beweglichen Nase (17) durchgriffen ist.

4. Anschlussvorrichtung für einen Stromzähler, mit einer den Stromzähler aufnehmenden Plattform (12) gemäß einem der Ansprüche 1 bis 3.

5. Stromzähleranordnung mit einer Plattform (12) gemäß einem der Ansprüche 1 bis 3, durch die ein Stromzähler gehalten und geführt werden kann.

6. Stromzähleranordnung nach Anspruch 5, wobei je eine feststehende Nase (15) an zwei entgegengesetzt liegenden Vorsprüngen (21, 22) angeformt sind, die senkrecht von der Bodenfläche des Gehäuses (12) vorspringen.

7. Stromzähleranordnung nach Anspruch 6, wobei an der entgegengesetzten Schmalseitenkante des Gehäuses (12) wenigstens ein Gehäusevorsprung (25) vorgesehen ist, der zwischen den beiden Vorsprüngen (21, 22) angeordnet und von je einer beweglichen Nase (17) durchgriffen ist.

8. Zählerplatz für einen Stromzähler, mit wenigstens einer Halteschiene, **gekennzeichnet durch** eine Vorrichtung zur Befestigung des Stromzählers an dem Zählerplatz, welche **durch** eine Plattform (12) gemäß einem der Ansprüche 1 bis 3, gebildet ist.

9. Zählerplatz nach Anspruch 8, wobei je eine feststehende Nase (15) an zwei entgegengesetzt liegenden Vorsprüngen (21, 22) angeformt sind, die senkrecht von der Bodenfläche des Gehäuses (12) vorspringen.

10. Zählerplatz nach Anspruch 9, wobei an der entgegengesetzten Schmalseitenkante des Gehäuses (12) wenigstens ein Gehäusevorsprung (25) vorgesehen ist, der zwischen den beiden Vorsprüngen (21, 22) angeordnet und von je einer beweglichen Nase (17) durchgriffen ist.

11. Zählerplatz nach Anspruch 8, wobei zwei parallel und horizontal verlaufende Schienen (10, 11; 27, 28) vorgesehen sind, die im montierten Zustand im Zählerplatz senkrecht übereinander liegen, wobei die feststehende Nase (15) die obere Kante (19, 29) der oberen Schiene (10, 27) und die bewegliche Nase (17) hinter die entgegengesetzt liegende untere Kante (20, 30) rastbar sind.

12. Zählerplatz nach Anspruch 8, wobei die wenigstens eine Halteschiene (27, 28) aus Flachbandmaterial gebildet ist.

13. Zählerplatz nach Anspruch 8, wobei die wenigstens eine Halteschiene (10, 11) als Hutprofiltragschiene ausgebildet ist.

## Claims

1. Platform (12) for attaching an electricity meter, wherein the platform (12) is formed by a housing, contact elements being provided in the interior of the said housing, a cutout being provided on the bottom face of said housing, at least one stationary lug (15) being provided on one end wall (14) of the said cutout, the said stationary lug facing the other end wall (16), and at least one moving lug (17) which is resiliently pushed in the direction of the stationary lug (15) being provided on the other end wall of the said cutout, so that the housing of the platform (12) can be snapped-in behind opposite edges (19, 20; 29, 30) of at least one mounting rail (10, 11; 27, 28).

2. Platform (12) according to Claim 1, wherein in each case one stationary lug (15) is integrally formed on two opposite projections (21, 22) which project perpendicularly from the base surface of the housing (12).

3. Platform (12) according to Claim 2, wherein at least one housing projection (25) is provided on the opposite narrow side edge of the housing (12), said housing projection being arranged between the two projections (21, 22), and in each case one moving lug (17) passing through the said housing projection.

4. Connection apparatus for an electricity meter, comprising a platform (12) according to one of Claims 1 to 3 which accommodates the electricity meter.

5. Electricity meter arrangement comprising a platform (12) according to one of Claims 1 to 3, which can hold and guide an electricity meter.

6. Electricity meter arrangement according to Claim 5, wherein in each case one stationary lug (15) is integrally formed on two opposite projections (21, 22) which project perpendicularly from the base surface of the housing (12).

7. Electricity meter arrangement according to Claim 6, wherein at least one housing projection (25) is provided on the opposite narrow side edge of the housing (12), the said housing projection being arranged between the two projections (21, 22), and in each case one moving lug (17) passing through the said housing projection.

8. Meter station for an electricity meter, comprising at least one mounting rail, **characterized by** an apparatus for fastening the electricity meter to the meter station, which apparatus is formed by a platform (12) according to one of Claims 1 to 3.

9. Meter station according to Claim 8, wherein in each case one stationary lug (15) is integrally formed on two opposite projections (21, 22) which project perpendicularly from the base surface of the housing (12).

10. Meter station according to Claim 9, wherein at least one housing projection (25) is provided on the opposite narrow side edge of the housing (12), the said housing projection being arranged between the two projections (21, 22), and in each case one moving lug (17) passing through the said housing projection.

11. Meter station according to Claim 8, wherein two parallel and horizontal rails (10, 11; 27, 28) are provided, the said rails being situated perpendicularly one above the other in the meter station in the mounted state, wherein the stationary lug (15) can latch the upper edge (19, 29) of the upper rail (10, 27), and the moving lug (17) can latch behind the opposite lower edge (20, 30).

12. Meter station according to Claim 8, wherein the at least one mounting rail (27, 28) is formed from flat strip material.

13. Meter station according to Claim 8, wherein the at least one mounting rail (10, 11) is in the form of a top-hat profile support rail.

## Revendications

1. Plate-forme (12) pour l'insertion d'un compteur électrique, la plate-forme (12) étant formée par un boîtier à l'intérieur duquel sont prévus des éléments de contact, sur le côté inférieur duquel est prévu un évidement au niveau d'une paroi d'extrémité (14) duquel est prévu au moins un ergot fixe (15) tourné vers l'autre paroi d'extrémité (16) et au niveau de son autre paroi d'extrémité, au moins un ergot mobile (17) pressé de manière élastique dans la direction de l'ergot fixe (15), de telle sorte que le boîtier de la plate-forme (12) puisse être encliqueté derrière des arêtes situées à l'opposé (19, 20 ; 29, 30) d'au moins un rail de retenue (10, 11 ; 27, 28).

2. Plate-forme (12) selon la revendication 1, dans laquelle un ergot fixe (15) respectif est façonné à chaque fois sur deux saillies opposées (21, 22) qui font saillie verticalement depuis la surface de fond du boîtier (12).

3. Plate-forme (12) selon la revendication 2, dans laquelle au niveau de l'arête opposée du côté étroit du boîtier (12) est prévue au moins une saillie de boîtier (25) qui est disposée entre les deux saillies (21, 22) et qui est traversée par un ergot mobile respectif (17).

4. Dispositif de raccordement pour un compteur électrique comprenant une plate-forme (12) selon l'une quelconque des revendications 1 à 3, recevant le compteur électrique.

5. Agencement de compteur électrique comprenant une plate-forme (12) selon l'une quelconque des revendications 1 à 3, par le biais de laquelle un compteur électrique peut être retenu et guidé.

6. Agencement de compteur électrique selon la revendication 5, dans lequel un ergot fixe respectif (15) est façonné à chaque fois sur deux saillies opposées (21, 22), lesquelles font saillie depuis la surface de fond du boîtier (12).

7. Agencement de compteur électrique selon la revendication 6, dans laquelle au niveau de l'arête opposée du côté étroit du boîtier (12) est prévue au moins une saillie de boîtier (25) qui est disposée entre les deux saillies (21, 22) et qui est traversée par un ergot mobile respectif (17).

8. Poste de compteur pour un compteur électrique, comprenant au moins un rail de retenue, **caractérisé par** un dispositif pour la fixation du compteur électrique sur le poste de compteur, lequel est formé par une plate-forme (12) selon l'une quelconque des revendications 1 à 3.

9. Poste de compteur selon la revendication 8, dans lequel un ergot fixe respectif (15) est façonné à chaque fois sur deux saillies opposées (21, 22), lesquelles font saillie depuis la surface de fond du boîtier (12).

10. Poste de compteur selon la revendication 9, dans lequel au niveau de l'arête opposée du côté étroit du boîtier (12) est prévue au moins une saillie de boîtier (25) qui est disposée entre les deux saillies (21, 22) et qui est traversée par un ergot mobile respectif (17).

11. Poste de compteur selon la revendication 8, dans lequel deux rails s'étendant parallèlement et horizontalement (10, 11 ; 27, 28) sont prévus, lesquels sont situés verticalement l'un au-dessus de l'autre dans l'état monté dans le poste de compteur, l'ergot fixe (15) pouvant s'encliqueter avec l'arête supérieure (19, 29) du rail supérieur (10, 27) et l'ergot mobile (17) pouvant s'encliqueter derrière l'arête inférieure opposée (20, 30).

12. Poste de compteur selon la revendication 8, dans lequel l'au moins un rail de retenue (27, 28) est formé sous forme de matériau en bande plat.

13. Poste de compteur selon la revendication 8, dans lequel l'au moins un rail de retenue (10, 11) est réalisé sous forme de rail porteur de profil en forme de chapeau.
